# EUROPEAN PATENT SPECIFICATION

(11) **EP 3 514 260 B1**
(45) Date of publication and mention of the grant of the patent: **20.10.2021**
(21) Application number: 18213261.3
(22) Date of filing: 18.12.2018
(51) Int. Cl.: C23C 16/455, C23C 16/44, C23C 16/54

(54) **THIN FILM DEPOSITION APPARATUS**
DÜNNSCHICHTABLAGERUNGSVORRICHTUNG
APPAREIL DE DÉPÔT DE FILM MINCE

(30) Priority: 19.12.2017 KR 20170174880
(43) Date of publication of application: 24.07.2019
(73) Proprietor: Tes Co., Ltd., Yongin-si, Gyeonggi-do 449-825 (KR)
(72) Inventor: Lee, Hong-Jae, Ansan-si, Gyeonggi-do 15275 (KR)
(74) Representative: Gulde & Partner

(56) References cited:
- KR-A- 20140 148 120
- US-A1- 2009 165 715
- US-A1- 2011 023 775
- US-A1- 2016 097 122
- US-A1- 2016 115 596

## Description

### Field of the Invention

Apparatuses and methods consistent with the present disclosure relate to a thin film deposition apparatus, and more particularly, to a thin film deposition apparatus for minimizing generation of powder at a gas supply unit for supplying process gas when a thin film is deposited by atomic layer deposition (ALD).

### Description of the Related Art

Technology such as chemical vapor deposition (CVD) and atomic layer deposition (ALD) has been used as a deposition method of forming a thin film on a substrate such as a semiconductor wafer (hereinafter referred to as a substrate).

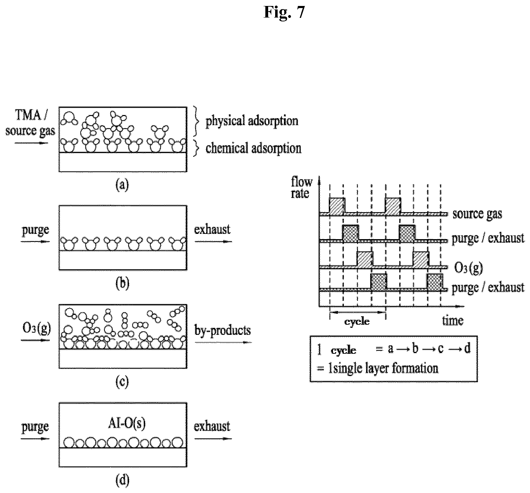

FIG. 7 is a schematic diagram showing a basic concept of ALD of a thin film deposition method. Referring to FIG. 7, source gas including a source material such as trimethyaluminium (TMA) is supplied onto a substrate to adsorb source gas onto the substrate, inert purge gas such as argon (Ar) is supplied to exhaust source gas that is not adsorbed and, then, reaction gas including a reactant such as ozone (O₃) which reacts with the source material is supplied to form a single atomic layer (Al-O) on the substrate and exhaust an unreactive material and a byproduct by suppling inert purge gas.

A conventional thin film deposition apparatus used in ALD temporally or spatially separates source gas and reaction gas and supplies the gas toward a substrate. Therefrom, the method of temporally separating and supplying source gas and reaction gas requires a pumping time halfway to decrease a substrate throughput of a thin film deposition apparatus. Further relevant prior art is disclosed in patent documents US 2016/0097122 A1 and US 2009/0165715 A1.

Accordingly, in consideration of the substrate throughput of the thin film deposition apparatus, the method of spatially separating and supplying source gas and reaction gas is advantageous. As such, an example of the method of spatially separating and supplying source gas and reaction gas is a scan type method in which a gas supply unit and a substrate are relatively moved with respect to each other.

However, even if source gas and reaction gas are spatially separated and supplied in the scan type method or the like, powder is generated from a parasitic reaction between source gas and reaction gas. The powder is mainly generated below a gas supply unit and, as a deposition process proceeds, the powder is accumulated below the gas supply unit. Accordingly, when the powder is dropped toward the substrate from the gas supply unit due to itself weight, the powder acts as a particle that contaminates a thin film.

### SUMMARY OF THE INVENTION

The invention is defined by the thin film deposition apparatus according to the appended claims.

The present disclosure provides a thin film deposition apparatus for maintaining the excellent quality of the thin film while maintaining high substrate throughput when a thin film is deposited on a substrate by atomic layer deposition (ALD).

The present disclosure also provides a thin film deposition apparatus for preventing a parasitic reaction between source gas and reaction gas to a maximum degree to minimize generation of powder when a gas supply unit and a substrate are relatively moved with respect to each other by atomic layer deposition (ALD).

According to an aspect of the present disclosure, a thin film deposition apparatus may comprise a chamber providing a deposition space in which a thin film is deposited on a substrate, a gas supply unit including at least one gas supply module supplying source gas and reaction gas toward the substrate and exhausting remaining gas, and disposed in the deposition space and a substrate support unit which is disposed below the gas supply unit, on which the substrate is mounted, and which is relatively moved with respect to the gas supply unit, wherein the gas supply module includes a pair of source gas supply channels supplying source gas toward the substrate, a reaction gas supply channel spaced apart from the pair of source gas supply channels and supplying reaction gas toward the substrate, and a first exhaust channel disposed between the pair of source gas supply channels and exhausting remaining gas.

The gas supply module may further include a pair of first purge gas supply channels supplying purge gas toward the substrate and symmetrically disposed outside the pair of source gas supply channels.

An exhaust channel exhausting remaining gas may be not disposed between the pair of source gas supply channels and the pair of first purge gas supply channels, each adjacent to each other.

The gas supply module may further comprise a second exhaust channel disposed between the reaction gas supply channel and one of the pair of first purge gas supply channels.

The gas supply module may further comprise an additional exhaust channel disposed adjacent to at least one of both edges of the gas supply module.

The gas supply module may further comprise a purge gas supply channel disposed outside the additional exhaust channel.

The pair of source gas supply channels and the pair of first purge gas supply channels may be disposed at one side of the reaction gas supply channel, and a third exhaust channel and a second purge gas supply channel are further disposed at the other side of the reaction gas supply channel.

At least one of the pair of first purge gas supply channels and the second purge gas supply channel may have a greater width than the pair of source gas supply channels and the reaction gas supply channel.

The gas supply module may further comprise an additional exhaust channel disposed adjacent to at least one of both edges of the gas supply module.

The gas supply module may further comprise a third purge gas supply channel disposed between the reaction gas supply channel and one of the pair of first purge gas supply channel.

The gas supply module may further comprise a fourth exhaust channel disposed between the reaction gas supply channel and the third purge gas supply channel.

At least one of the pair of first purge gas supply channel, the second purge gas supply channel, and the third purge gas supply channel may have a greater width than the pair of source gas supply channel and the reaction gas supply channel.

The gas supply module may further comprise a guide member disposed at an end of at least one of the pair of source gas supply channels and guiding a supplying direction of the source gas.

The guide member may guide source gas supplied from the pair of source gas supply channels to be directed toward the first exhaust channel.

### BRIEF DESCRIPTION OF THE DRAWING FIGURES

The above and/or other aspects of the present disclosure will be more apparent by describing certain exemplary embodiments of the present disclosure with reference to the accompanying drawings, in which:
FIG. 1 is a lateral cross-sectional view showing an internal configuration of a thin film deposition apparatus according to an exemplary embodiment;
FIG. 2 is an enlarged cross-sectional view of a gas supply module according to an exemplary embodiment;
FIGS. 3 to 6 are lateral cross-sectional views showing a configuration of a gas supply module according to another exemplary embodiments; and
FIG. 7 is a schematic diagram showing a basic concept of a conventional atomic layer deposition (ALD) apparatus.

### DETAILED DESCRIPTION OF THE EXEMPLARY EMBODIMENTS

Hereinafter, a thin film deposition apparatus according to various embodiments of the present disclosure will be described in greater detail with reference to the accompanying drawings.

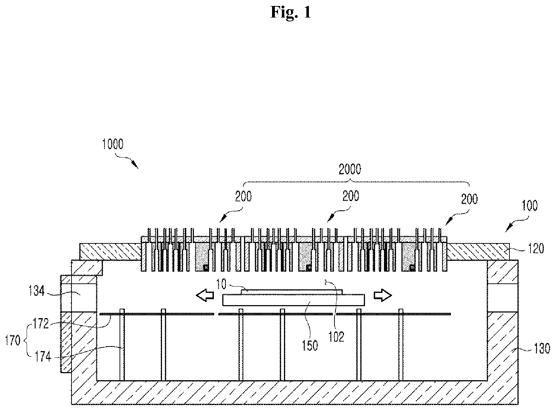

FIG. 1 is a lateral cross-sectional view showing an internal configuration of a thin film deposition apparatus 1000 according to an exemplary embodiment.

Referring to FIG. 1, the thin film deposition apparatus 1000 may include a chamber 100 that provides a deposition space 102 in which a thin film is deposited on a substrate 10 and the substrate 10 is loaded to perform a deposition operation, and a substrate loading/unloading device (not shown) for loading and unloading of a substrate. Although not shown in the drawing, the thin film deposition apparatus 1000 may further include a load lock chamber that is connected to one side of the chamber 100 and is switchable to a vacuum or atmospheric pressure state, one or more boats on which a substrate to be deposited is accommodated, and one or more boats on which a completely deposited substrate is accommodated.

The thin film deposition apparatus 1000 may include the chamber 100 including the deposition space 102 in which a thin film is deposited on the substrate 10, a substrate support unit 150 which is included in the chamber 100 and on which the substrate is mounted, and a gas supply unit 2000.

Here, the gas supply unit 2000 may include at least one gas supply module 200 for supplying source gas and reaction gas toward the substrate 10 and exhausting the remaining gas and may be disposed in upper part of the deposition space 102.

In this case, the gas supply unit 2000 may be spaced apart from the substrate support unit 150 by a predetermined distance and may be configured to be relatively moved with respect to the substrate support unit 150. Furthermore, the thin film deposition apparatus 1000 may include a loading/unloading means of loading the substrate 10 into the chamber 100, or unloading the substrate 10 from the chamber 100.

The chamber 100 may provide a space in which the substrate 10 is loaded, a deposition operation or the like is performed on the substrate 10, and various components are disposed. In addition, the chamber 100 may provide an environment in which a vacuum state is maintained therein by vacuum equipment such as a pump (not shown) for exhausting internal gas to perform a substrate processing operation such as a deposition operation or the like.

In detail, the chamber 100 may include the deposition space 102 disposed therein and may include a chamber body 130 with an open upper part and a chamber lid 120 for opening and closing the open upper part of the chamber body 130. An opening 134 for loading and unloading of the substrate 10 into and out of the chamber 100 may be disposed at one side of the chamber body 130.

The chamber lid 120 of the chamber 100 may include the gas supply unit 2000 for supplying at least one of source gas, reaction gas, and purge gas, which is described below in detail.

The substrate support unit 150 on which the substrate 10 is mounted may be included in the chamber 100. The substrate support unit 150 may be configured to be relatively moved with respect to the aforementioned gas supply unit 2000. That is, at least one of the substrate support unit 150 and the gas supply unit 2000 may be configured in such a way that at least one of the substrate support unit 150 and the gas supply unit 2000 is relatively moved along a straight-line path by a predetermined distance in a parallel to the other one of the substrate support unit 150 and the gas supply unit 2000. When being relatively moved, the substrate support unit 150 and the gas supply unit 2000 may reciprocate along a predetermined straight-line path.

For example, when the gas supply unit 2000 disposed in upper part of the deposition space 102 sequentially supplies source gas, reaction gas, and the like, if the substrate support unit 150 reciprocates while being relatively moved below the gas supply unit 2000, a thin film may be deposited on the substrate 10 at high deposition rate by source gas and reaction gas that are supplied by the gas supply unit 2000.

In this case, both the gas supply unit 2000 and the substrate support unit 150 may be configured to be relatively moved or any one of the gas supply unit 2000 and the substrate support unit 150 may be relatively moved with respect to the other one. For example, the gas supply unit 2000 and the substrate support unit 150 may be configured in such a way that the aforementioned gas supply unit 2000 is fixed and the substrate support unit 150 is moved or both the substrate support unit 150 and the gas supply unit 2000 are moved.

A heater 170 for heating the substrate 10 may be disposed below the substrate support unit 150. The heater 170 may be spaced apart from a bottom of the substrate support unit 150 for supporting the substrate 10 by a predetermined distance to heat the substrate 10.

In detail, the heater 170 may be disposed along a moving path of the substrate support unit 150. For example, the heater 170 may include at least one heating plate 172 and a support member 174 for supporting the heating plate 172. The heating plate 172 may be disposed to be spaced apart from the substrate support unit 150 for supporting the substrate 10 by a predetermined distance to heat the substrate 10.

Meanwhile, in exemplary embodiments, the heater 170 may be provided inside the substrate support unit 150.

The gas supply unit 2000 may include at least one gas supply module 200 for supplying source gas and reaction gas toward the substrate 10 and exhausting the remaining gas and, in detail, may include the plurality of gas supply modules 200 disposed along a moving path of the substrate 10. In this case, each of the gas supply modules 200 may supply source gas and reaction gas toward the substrate 10 and may exhaust the remaining gas. Accordingly, when the gas supply unit 2000 is configured, the plurality of gas supply modules 200 with the same configuration may be disposed to easily assemble the gas supply unit 2000. In this case, when the gas supply unit 2000 is repaired in the future, only the corresponding gas supply module 200 may be repaired or replaced to enable easy and rapid maintenance.

When the gas supply module 200 sequentially supplies source gas and reaction gas to deposit a thin film by atomic layer deposition (ALD), source gas may be first adsorbed onto the substrate 10 and the source gas adsorbed onto the substrate 10 may react with reaction gas to deposit the thin film. However, when a parasitic reaction between source gas and reaction gas occurs in a remaining region except for the substrate 10 on which a thin film needs to be deposited, powder may be generated and deposited. In particular, the powder may be generated and deposited at the gas supply module for supplying source gas and reaction gas.

For example, source gas supplied from a source gas supply channel of the gas supply module may be spread to both directions of the source gas supply channel and may be exhausted through an exhaust channel. In this case, reaction gas and purge gas may also be exhausted together by pumping of the exhaust channel. In this case, a portion of the reaction gas may be moved to the source gas supply channel due to a weakened gas curtain effect during exhausting of the purge gas to the exhaust channel. Accordingly, the reaction gas and the source gas may react with each other to generate powder at an outer part of a lower portion of the source gas supply channel.

As subsequent processes may be repeatedly performed, an amount of the generated powder is increased and, thus, the powder is dropped toward a substrate due to itself weight and acts as a particle that degrades the quality of a thin film of a substrate. Hereinafter, a configuration of a gas supply module for preventing a parasitic reaction in a gas supply module for supplying source gas and reaction gas if possible and reducing generation and deposition of powder to deposit a thin film by atomic layer deposition (ALD) will be described.

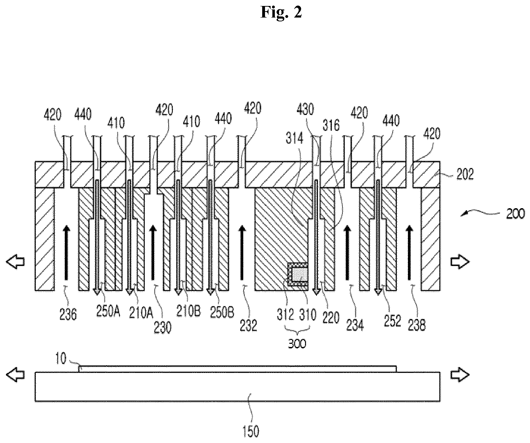

FIG. 2 is an enlarged cross-sectional view of the gas supply unit 2000 of FIG. 1 and a lateral cross-sectional view showing only one of a plurality of the supply modules 200 included in the gas supply unit 2000. As described above, at least one of the substrate support unit 150 and the gas supply module 200 may be configured to be relatively moved in parallel to the other one of the substrate support unit 150 and the gas supply module 200 by a predetermined distance.

Referring to FIG. 2, the gas supply module 200 may include a cover 202.

The cover 202 may be disposed above the gas supply module 200. The gas supply module 200 may include various lines for supplying or exhausting source gas, reaction gas, or purge gas to various supply channels to be described below in detail and the various lines may be disposed in the cover 202.

In detail, the gas supply module 200 may include a first supply line 410 for supplying source gas. The first supply line 410 may be connected to a source gas source (not shown) and may supply source gas to source gas supply channels 210A and 210B of the gas supply module 200 through the cover 202.

The gas supply module 200 may further include a second supply line 430 for supplying reaction gas. The second supply line 430 may be connected to a reaction gas source (not shown) and may supply reaction gas to a reaction gas supply channel 220 through the cover 202.

The gas supply module 200 may further include a third supply line 440 for supplying purge gas. The third supply line 440 may be connected to a purge gas source (not shown) and may supply purge gas to purge gas supply channels 250A, 250B, and 252 through the cover 202.

The gas supply module 200 may include an exhaust line 420 disposed in the cover 202 to exhaust source gas, reaction gas, or purge gas, which is supplied from various supply channels. The exhaust line 420 may be connected to exhaust channels 230, 232, 234, 236, and 238 and may exhaust the remaining gas inside the chamber 100 by pumping of a pumping member.

The gas supply module 200 may include various supply channels for supplying source gas, reaction gas, and/or purge gas. At least one supply channel may be disposed in the gas supply module 200.

In detail, the gas supply module 200 may include the pair of source gas supply channels 210A and 210B for supplying source gas to the substrate 10, and the reaction gas supply channel 220 that is spaced apart from the pair of source gas supply channels 210A and 210B to supply reaction gas to the substrate 10.

The source gas supply channels 210A and 210B may supply source gas to the substrate 10 and the reaction gas supply channel 220 may be spaced apart from one side the source gas supply channels 210A and 210B by a predetermined distance to supply reaction gas toward the substrate 10.

In this case, if the gas supply module 200 is configured in such a way that the source gas supply channels 210A and 210B and the reaction gas supply channel 220 are disposed adjacently to each other, a parasitic reaction between source gas and reaction gas may occur and, thus, the gas supply module 200 may be configured in such a way that the source gas supply channels 210A and 210B and the reaction gas supply channel 220 may be spaced apart from each other to a maximum distance.

For example, as shown in the drawing, the gas supply module 200 may be configured in such a way that source gas supply channels 210A and 210B and the reaction gas supply channel 220 are disposed at both sides of the gas supply module 200, respectively. That is, the source gas supply channels 210A and 210B may be disposed at any one of the both sides of the gas supply module 200 and the reaction gas supply channel 220 may be disposed at the other one of the both sides of the gas supply module 200, thereby maximizing a distance between the source gas supply channels 210A and 210B and the reaction gas supply channel 220.

According to the present exemplary embodiment, the gas supply module 200 may include the first exhaust channel 230 between the pair of source gas supply channels 210A and 210B to exhaust the remaining gas. When the pair of source gas supply channels 210A and 210B are configured, the first exhaust channel 230 may be disposed between the source gas supply channels 210A and 210B. In this case, the source gas may be supplied toward the substrate 10 from the source gas supply channels 210A and 210B and, then, the source gas that is not adsorbed onto the substrate 10 may be exhausted by the first exhaust channel 230.

In particular, according to the present exemplary embodiment the first exhaust channel 230 is disposed between the pair of source gas supply channels 210A and 210B for supplying the source gas and, thus, it may be possible to exhaust unreacted source gas that is supplied from the source gas supply channels 210A and 210B and does not participate in a reaction by pumping by the first exhaust channel 230 prior to being moved to the reaction gas supply channel 220. Accordingly, the unreacted source gas that is not adsorbed onto the substrate 10 from the source gas supplied from the source gas supply channels 210A and 210B may be prevented from being moved toward the reaction gas supply channel 220 to reduce a parasitic reaction between the source gas and the reaction gas.

The gas supply module 200 may further include the pair of first purge gas supply channels 250A and 250B for supplying purge gas toward the substrate 10. One of the pair of first purge gas supply channels 250B may be disposed between one of the source gas supply channels 210B and the reaction gas supply channel 220 to supply purge gas to prevent the source gas and the reaction gas from meeting, thereby reducing a parasitic reaction.

In detail, the gas supply module 200 may include the pair of first purge gas supply channels 250A and 250B for supplying purge gas. In this case, the pair of source gas supply channels 210A and 210B and the pair of first purge gas supply channels 250A and 250B may be adjacently disposed to each other.

That is, source gas supplied from the source gas supply channels 210A and 210B may be prevented from being moved to the reaction gas supply channel 220 to reduce a parasitic reaction by purge gas supplied by the pair of first purge gas supply channels 250A and 250B.

In this case, the pair of first purge gas supply channels 250A and 250B may be symmetrically disposed outside the pair of source gas supply channels 210A and 210B.

That is, the aforementioned first exhaust channel 230 may be disposed between the pair of source gas supply channels 210A and 210B and the first purge gas supply channels 250A and 250B may be symmetrically disposed outside the pair of source gas supply channels 210A and 210B, respectively.

Accordingly, unreacted source gas that is supplied from the source gas supply channels 210A and 210B and does not participates in a reaction may be exhausted by the first exhaust channel 230 disposed at a central parts between the pair of source gas supply channels 210A and 210B. In this case, purge gas supplied from the pair of first purge gas supply channels 250A and 250B disposed at an outer part of the pair of source gas supply channels 210A and 210B may function as a kind of gas curtain to prevent the source gas from being spread to both sides of the source gas supply channels 210A and 210B.

When the pair of first purge gas supply channels 250A and 250B are symmetrically disposed outside the pair of source gas supply channels 210A and 210B as described above, there may be no exhaust channel for exhausting the remaining gas between the pair of source gas supply channels 210A and 210B and the pair of first purge gas supply channels 250A and 250B, each adjacent to each other.

If the exhaust channel for exhausting the remaining gas is present between the source gas supply channels 210A and 210B and the first purge gas supply channels 250A and 250B, source gas supplied from the source gas supply channels 210A and 210B may be exhausted and reaction gas supplied from the reaction gas supply channel 220 may also be pumped and exhausted together. In this case, a parasitic reaction between source gas and reaction gas may occur in the exhaust channel presented between the source gas supply channels 210A and 210B and the first purge gas supply channels 250A and 250B to generate powder. Accordingly, according to the present exemplary embodiment, the exhaust channel for exhausting the remaining gas may not be present between the source gas supply channels 210A and 210B and the first purge gas supply channels 250A and 250B and, thus, source gas supplied to the source gas supply channels 210A and 210B may be prevented from being spread to both sides and meeting reaction gas, thereby preventing a parasitic reaction therebetween to a maximum.

Furthermore, the exhaust channel for exhausting the remaining gas may not be present between the source gas supply channels 210A and 210B and the first purge gas supply channels 250A and 250B and, thus, the gas supply module 200 may be compact

The gas supply module 200 may include the reaction gas supply channel 220 that is spaced apart from the aforementioned pair of source gas supply channels 210A and 210B to supply reaction gas.

In this case, the pair of first purge gas supply channels 250A and 250B may be symmetrically disposed outside the pair of source gas supply channels 210A and 210B, respectively, and the second exhaust channel 232 may be disposed between the reaction gas supply channel 220 and one the pair of first purge gas supply channels 250A and 250B.

That is, the second exhaust channel 232 may be further disposed between one of the pair of first purge gas supply channel 250A and 250B and the reaction gas supply channel 220. Accordingly, source gas that is supplied from one of the source gas supply channels 210B and passes through a lower portion of one of the first purge gas supply channels 250B may be exhausted prior to reaching the reaction gas supply channel 220.

As described above, when the pair of source gas supply channels 210A and 210B and the pair of first purge gas supply channels 250A and 250B are disposed at one side of the reaction gas supply channel 220, the third exhaust channel 234 may be further disposed at the other side of the reaction gas supply channel 220.

In this case, as shown in the drawing, the third exhaust channel 234 may correspond to an exhaust channel disposed on the right side of the reaction gas supply channel 220. In this case, the third exhaust channel 234 may be disposed between the reaction gas supply channel 220 and a source gas supply channel (not shown) of another gas supply module (not shown) disposed on the right side of the gas supply module 200. Accordingly, a parasitic reaction between source gas and reaction gas may be prevented by the third exhaust channel 234.

When the third exhaust channel 234 is omitted, the exhaust channel 236 shown at the outermost of the left side of the gas supply module 200 may perform a similar function to that of the omitted third exhaust channel 234. That is, if another gas supply module (not shown) is disposed on the left side of the gas supply module 200, an exhaust channel may be formed between the source gas supply channel 210A of the gas supply module 200 and a reaction gas supply channel of a gas supply module that is not shown to prevent a parasitic reaction.

As a result, an additional exhaust channel may be disposed adjacent to at least one of both edges of the gas supply module 200 and, in this case, the additional exhaust channel may correspond to the third exhaust channel 234 or the exhaust channel 236 shown at the outermost of the left side of the gas supply module 200.

The second purge gas supply channel 252 may be further disposed outside the third exhaust channel 234. The second purge gas supply channel 252 may be disposed between the reaction gas supply channel 220 and a source gas supply channel (not shown) of another gas supply module (not shown) disposed on the right side of the gas supply module 200. Accordingly, a parasitic reaction between source gas and reaction gas may be prevented by the second purge gas supply channel 252.

When the second purge gas supply channel 252 is omitted, the first purge gas supply channel 250A disposed on the left side among the pair of first purge gas supply channels 250A and 250B may perform a similar function to the omitted second purge gas supply channel 252. That is, if another gas supply module (not shown) is disposed on the left side of the gas supply module 200, the first purge gas supply channel 250A may be formed between the source gas supply channel 210A of the gas supply module 200 and a reaction gas supply channel of a gas supply module that is not shown to prevent a parasitic reaction.

As a result, the gas supply module 200 according to the present exemplary embodiment may be configured in such a way that relatively many purge gas supply channels are disposed between the reaction gas supply channel and the source gas supply channel in one gas supply module 200, compared with a conventional device. In addition, when the gas supply modules 200 according to the present exemplary embodiment are consecutively disposed, relatively many purge gas supply channels may also be disposed between a reaction gas supply channel of any one of the gas supply modules 200 and a source gas supply channel of another gas supply module. In the case of this configuration, a parasitic reaction between source gas and reaction gas may be prevented by a gas curtain effect of purge gas supplied from the purge gas supply channel.

As illustrated in FIG. 1, the gas supply unit 2000 of the thin film deposition apparatus 1000 according to the present disclosure may include the plurality of gas supply modules 200 which are installed in upper part of the deposition space 102 of the chamber 100 along a moving path of the substrate 10. That is, a gas supply module that is not shown in the drawing with the same configuration may be disposed on the right side of the gas supply module 200 shown in FIG. 2.

In this case, a parasitic reaction between reaction gas supplied from the reaction gas supply channel 220 of the gas supply module 200 that is shown in the drawing and source gas supplied from a source gas supply channel of a gas supply module that is not shown in the drawing may occur.

Accordingly, to prevent such a parasitic reaction, the third exhaust channel 234 and the second purge gas supply channel 252 may be disposed at the right side of the reaction gas supply channel 220. Reaction gas that is supplied from the reaction gas supply channel 220 and does not participate in a reaction may be exhausted through the third exhaust channel 234. In addition, purge gas supplied from the second purge gas supply channel 252 may act as a gas curtain to prevent a parasitic reaction between reaction gas and source gas.

The gas supply module 200 may include an additional exhaust channel disposed adjacent to at least one of both edges.

As shown in FIG. 2, the additional exhaust channel may correspond to an exhaust channel denoted by '236' and '238' or, when the second purge gas supply channel 252 is omitted, the additional exhaust channel may correspond to the exhaust channel denoted by '236' and '234'.

As such, the additional exhaust channel may be disposed adjacent to at least one of the both edges of the gas supply module 200, thereby preventing a parasitic reaction between source gas or reaction gas supplied from a gas supply module (not shown) that is to neighbor both sides of the gas supply module 200 and reaction gas or source gas supplied from the gas supply module 200.

When a thin film is deposited on the substrate 10 by atomic layer deposition (ALD), a gas activation unit 300 for activating reaction gas may be disposed at the reaction gas supply channel 220.

The gas activation unit 300 described in the present embodiment may activate reaction gas to supply the reaction gas in an activated atom or radical. Here, the gas activation unit 300 may be provided in any one form of a plasma generation unit, a super high frequency generation unit, an ultraviolet irradiation unit, and a laser irradiation unit.

For example, when the gas activation unit 300 is configured in the form of a high frequency generation unit, the high frequency generation unit may activate reaction gas using a high frequency equal to or greater than 10⁹ Hz. When the high frequency generation unit applies a high frequency, the reaction gas may be changed to an activated atom or radical state and may be supplied toward the substrate 10.

When the gas activation unit 300 is configured in the form of an ultraviolet irradiation unit, reaction gas may be changed to an activated atom or radical state by ultraviolet rays emitted by the ultraviolet irradiation unit and may be supplied toward the substrate 10.

When the gas activation unit 300 is configured in the form of a laser irradiation unit, reaction gas may be changed to an activated atom or radical state by laser beams emitted by the laser irradiation unit and may be supplied toward the substrate 10.

Hereinafter, a detailed description will be given assuming that the gas activation unit 300 is a plasma generation unit. When the gas activation unit 300 includes a plasma generation unit, a power electrode 310 supplied with power may be disposed to one side internal wall 314 of the reaction gas supply channel 220 and the other side internal wall 316 of the reaction gas supply channel 220 may be grounded to function as a ground electrode. In this case, a shield member 312 may be disposed at the one side internal wall 314 of the reaction gas supply channel 220 and may support the power electrode 310. The shield member 312 may electrically separate the power electrode 310 and the gas supply module 200 to electrically shield the power electrode 310 from the gas supply module 200. In this case, the shield member 312 may electrically shied the power electrode 310 and may also function as a support for supporting the power electrode 310.

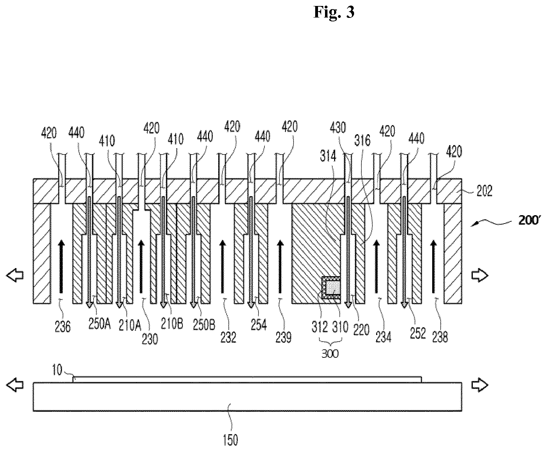

FIG. 3 is a lateral cross-sectional view showing a configuration of a gas supply module 200' according to another exemplary embodiment. In the exemplary embodiment shown in FIG. 3, the same reference numeral may be denoted for the same component as in the exemplary embodiment shown in FIG. 2.

Referring to FIG. 3, the gas supply module 200' according to the present exemplary embodiment may further include a third purge gas supply channel 254 between the reaction gas supply channel 220 and the first purge gas supply channel 250B.

In FIG. 3, the aforementioned second exhaust channel 232 may be disposed on the left side of the third purge gas supply channel 254 and a fourth exhaust channel 239 may be disposed between the third purge gas supply channel 254 and the reaction gas supply channel 220.

In this case, compared with the exemplary embodiment shown in FIG. 2, a distance between the source gas supply channels 210A and 210B and the reaction gas supply channel 220 may be further increased. In addition, an effect of a gas curtain may be further enhanced by purge gas supplied from the third purge gas supply channel 254. The fourth exhaust channel 239 may be further included to more effectively exhaust the remaining gas. Accordingly, a parasitic reaction between source gas supplied from the source gas supply channels 210A and 210B and reaction gas supplied from the reaction gas supply channel 220 may be prevented.

The other components except for the aforementioned components of FIG. 3 have been described above with reference to FIG. 2 and, thus, a repeated description is omitted.

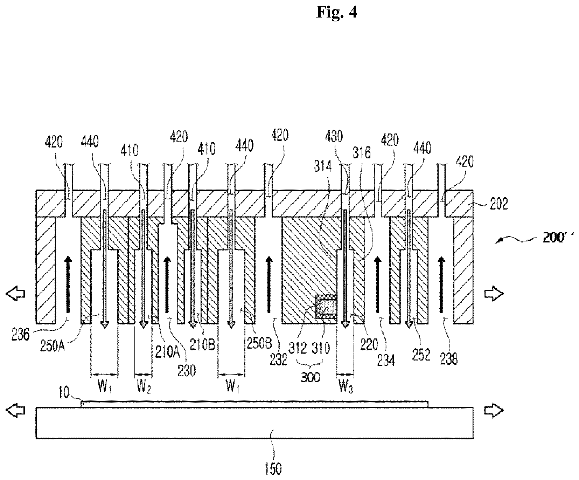

FIG. 4 is a lateral cross-sectional view showing a configuration of a gas supply module 200" according to another exemplary embodiment.

Referring to FIG. 4, compared with the exemplary embodiment of FIG. 2, the gas supply module 200" according to the present exemplary embodiment may be configured in such a way that at least one of the pair of first purge gas supply channels 250A and 250B and the second purge gas supply channel 252 has a greater width than the pair of source gas supply channels 210A and 210B and the reaction gas supply channel 220.

For example, a width W₁ of the pair of first purge gas supply channels 250A and 250B may be greater than a width W₂ of the pair of source gas supply channels 210A and 210B and a width W₃ of the reaction gas supply channel 220.

In this case, a distance between the source gas supply channels 210A and 210B and the reaction gas supply channel 220 may be increased and a width of purge gas supplied from the pair of first purge gas supply channels 250A and 250B may be increased to enhance an effect of a gas curtain compared with the exemplary embodiments of FIG. 1 and 1. As a pressure of purge gas supplied from the pair of first purge gas supply channels 250A and 250B is increased, the effect of a gas curtain may be further enhanced. Although not shown in the drawing, a width of at least one of various exhaust channels such as the first exhaust channel 230, the second exhaust channel 232, the third exhaust channel 234, the additional exhaust channels 236 and 238 may be increased or a pumping capacity may be increased and, thus, a parasitic reaction between source gas supplied from the source gas supply channels 210A and 210B and reaction gas supplied from the reaction gas supply channel 220 may be prevented.

Although FIG. 4 shows the case in which the width W₁ of the pair of first purge gas supply channels 250A and 250B is relatively wide, the present disclosure is not limited thereto. Alternatively, the width of the second purge gas supply channel 252 may also be relatively wide or the widths of the pair of first purge gas supply channels 250A and 250B and the second purge gas supply channel 252 may also be wide.

The other components except for the aforementioned components of FIG. 4 have been described above with reference to FIG. 2 and, thus, a repeated description is omitted.

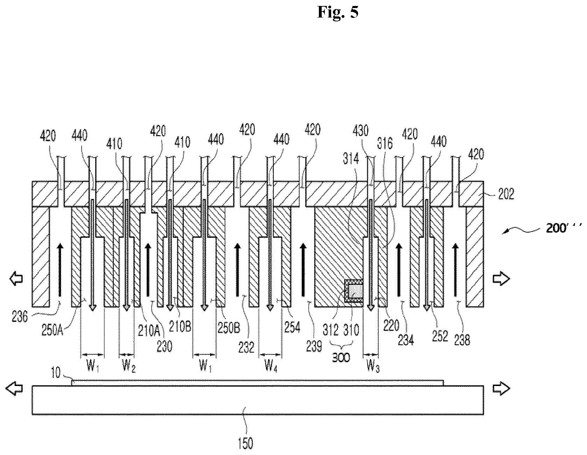

FIG. 5 is a lateral cross-sectional view showing a configuration of a gas supply module 200‴ according to another exemplary embodiment.

Referring to FIG. 5, compared with the exemplary embodiment of FIG. 3, the gas supply module 200'" according to the present exemplary embodiment may be configured in such a way that a width of at least one of the pair of first purge gas supply channels 250A and 250B, the second purge gas supply channel 252, and the third purge gas supply channel 254 has a greater width than the pair of source gas supply channels 210A and 210B and the reaction gas supply channel 220.

For example, the width W₁ of the pair of first purge gas supply channels 250A and 250B may be wider than the width W₂ of the pair of source gas supply channels 210A and 210B and the width W₃ of the reaction gas supply channel 220.

The width W₄ of the third purge gas supply channel 254 may also be wider than the width W₂ of the source gas supply channels 210A and 210B and the width W₃ of the reaction gas supply channel 220.

In this case, compared with the exemplary embodiment of FIG. 3, a distance between the source gas supply channels 210A and 210B and the reaction gas supply channel 220 may be further increased and a width of purge gas supplied from the pair of first purge gas supply channels 250A and 250B may be increased to further enhance an effect of a gas curtain. As a pressure of purge gas supplied from the pair of first purge gas supply channels 250A and 250B, the second purge gas supply channel 252, or the third purge gas supply channel 254 is increased, the effect of the gas curtain of the purge gas may be further enhanced. Although not shown in the drawing, a width of at least one of various exhaust channels such as the first exhaust channel 230, the second exhaust channel 232, the third exhaust channel 234, and the additional exhaust channels 236 and 238 may be increased or a pumping capacity may be increased and, thus, parasitic reaction between source gas supplied from the source gas supply channels 210A and 210B and reaction gas supplied from the reaction gas supply channel 220 may be prevented to a maximum.

Although FIG. 5 shows the case in which the width of the pair of first purge gas supply channels 250A and 250B and the third purge gas supply channel 254 is relatively wide, the present disclosure is not limited thereto. Alternatively, the width of the second purge gas supply channel 252 may also be relatively wide or the widths of all purge gas supply channels may also be wide.

The other components except for the aforementioned components of FIG. 5 have been described above with reference to FIG. 3 and, thus, a repeated description is omitted.

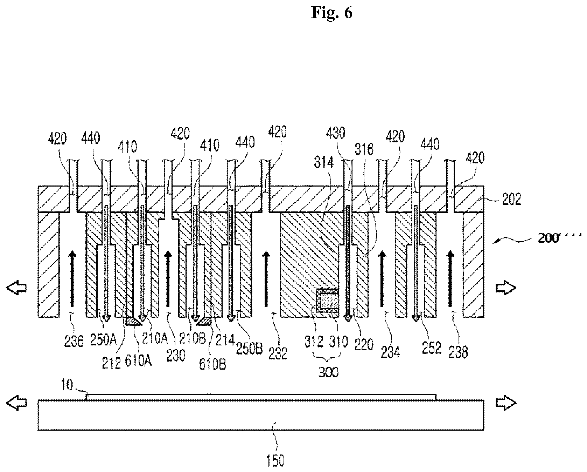

FIG. 6 is a lateral cross-sectional view showing the gas supply module 200 according to another exemplary embodiment.

Referring to FIG. 6, compared with the exemplary embodiment of FIG. 2, the gas supply module 200'" according to the present exemplary embodiment may further include guide members 610A and 610B disposed at an end of at least one of the pair of source gas supply channels 210A and 210B to guide a supply direction of the source gas.

As described above, the gas supply module 200 according to the present disclosure may be provided to prevent a parasitic reaction between source gas supplied from the source gas supply channels 210A and 210B and reaction gas supplied from the reaction gas supply channel 220. To this end, the source gas supplied from the source gas supply channels 210A and 210B may not be moved to the reaction gas supply channel 220, and a distance between the source gas supply channels 210A and 210B and the reaction gas supply channel 220 may also be increased to a maximum degree.

According to the present exemplary embodiment, the gas supply module 200'" may include guide members 610A and 610B for preventing source gas supplied from the pair of source gas supply channels 210A and 210B from being moved to the reaction gas supply channel 220 and directing the source gas toward the first exhaust channel 230.

In detail, the guide members 610A and 610B may be formed to be directed toward the first exhaust channel 230 from an end of both external walls 212 and 214 of the pair of source gas supply channels 210A and 210B. Accordingly, source gas supplied from the pair of source gas supply channels 210A and 210B may be supplied toward the first exhaust channel 230 and may be adsorbed onto the substrate 10, and source gas that is not adsorbed onto the substrate 10 may be exhausted through the first exhaust channel 230 to prevent a parasitic reaction with reaction gas.

Although FIG. 6 shows the case in which the guide member 610 protrudes downward from an end of the both external walls 212 and 214 of the pair of source gas supply channels 210A and 210B, the guide member 610 is not limited thereto. For example, the guide member 610 may protrude inward from an inside of the both external walls 212 and 214 or the pair of source gas supply channels 210A and 210B may also be inclined with respect to each other to function as a guide member

The aforementioned guide members 610A and 610B may also be applied to a structure of the gas supply module 200′, 200ʺ, 200‴ according to the exemplary embodiments of FIGS. 3 to 5.

According to the present disclosure with the aforementioned configuration, when a gas supply unit and a substrate are relatively moved with respect to each other by atomic layer deposition (ALD), a parasitic reaction between source gas and reaction gas may be prevented to a maximum degree to reduce generation of powders that are the cause of a particle.

Accordingly, according to the present disclosure, when a thin film is deposited on a substrate by ALD, the excellent quality of the thin film may be maintained while maintaining high substrate throughput.

The foregoing exemplary embodiments and advantages are merely exemplary and are not to be construed as limiting the present disclosure. The present teaching can be readily applied to other types of apparatuses. Also, the description of the exemplary embodiments of the present disclosure is intended to be illustrative, and not to limit the scope of the claims, and many alternatives, modifications, and variations will be apparent to those skilled in the art.

## Claims

1. A thin film deposition apparatus comprising:
a chamber (100) providing a deposition space (102) in which a thin film is deposited on a substrate (10);
a gas supply unit (2000) including at least one gas supply module (200) supplying source gas and reaction gas toward the substrate and exhausting remaining gas, and disposed in the deposition space; and
a substrate support unit (150) which is disposed below the gas supply unit, on which the substrate is mounted, and which is relatively moved with respect to the gas supply unit,
wherein the gas supply module (200) includes a pair of source gas supply channels (210A and 210B) supplying source gas toward the substrate, a reaction gas supply channel (220) spaced apart from the pair of source gas supply channels (210A and 210B) and supplying reaction gas toward the substrate, and a first exhaust channel (230) disposed between the pair of source gas supply channels and exhausting remaining gas,, wherein the gas supply module (200) further includes a pair of first purge gas supply channels (250A and 250B) supplying purge gas toward the substrate and symmetrically disposed outside the pair of source gas supply channels,
**characterized in that** an exhaust channel exhausting remaining gas is not disposed between the pair of source gas supply channels (210A and 210B) and the pair of first purge gas supply channels (250A and 250B), each adjacent to each other.

2. The thin film deposition apparatus of claim 1, wherein the gas supply module (200) further comprises a second exhaust channel (232) disposed between the reaction gas supply channel (220) and one of the pair of first purge gas supply channels.

3. The thin film deposition apparatus of claim 1, wherein the gas supply module (200) further comprises an additional exhaust channel disposed adjacent to at least one of both edges of the gas supply module.

4. The thin film deposition apparatus of claim 3, wherein the gas supply module (200) further comprises a purge gas supply channel disposed outside the additional exhaust channel.

5. The thin film deposition apparatus of claim 2, wherein the pair of source gas supply channels (210A and 210B) and the pair of first purge gas supply channels (250A and 250B) are disposed at one side of the reaction gas supply channel (220), and a third exhaust channel (234) and a second purge gas supply channel (252) are further disposed at the other side of the reaction gas supply channel.

6. The thin film deposition apparatus of claim 5, wherein at least one of the pair of first purge gas supply channels (250A and 250B) and the second purge gas supply channel (252) has a greater width than the pair of source gas supply channels (210A and 210B) and the reaction gas supply channel.

7. The thin film deposition apparatus of claim 5, wherein the gas supply module (200) further comprises an additional exhaust channel disposed adjacent to at least one of both edges of the gas supply module.

8. The thin film deposition apparatus of claim 7, wherein the gas supply module (200) further comprises a third purge gas supply channel disposed between the reaction gas supply channel and one of the pair of first purge gas supply channel.

9. The thin film deposition apparatus of claim 8, wherein the gas supply module further comprises a fourth exhaust channel (254) disposed between the reaction gas supply channel and the third purge gas supply channel.

10. The thin film deposition apparatus of claim 8, wherein at least one of the pair of first purge gas supply channel (250A and 250B), the second purge gas supply channel (252), and the third purge gas supply channel (254) has a greater width than the pair of source gas supply channel and the reaction gas supply channel.

11. The thin film deposition apparatus of claim 5, wherein the gas supply module further comprises a guide member (610) disposed at an end of at least one of the pair of source gas supply channels (210A and 210B) and guiding a supplying direction of the source gas.

12. The thin film deposition apparatus of claim 11, wherein the guide member (610) is configured to guide source gas supplied from the pair of source gas supply channels (210A and 210B) to be directed toward the first exhaust channel.

## Patentansprüche

1. Dünnschichtabscheidungsvorrichtung, umfassend:
eine Kammer (100), die einen Abscheidungsraum (102) bereitstellt, in dem eine Dünnschicht auf einem Substrat (10) abgeschieden wird;
eine Gaszufuhreinheit (2000), die mindestens ein Gaszufuhrmodul (200) umfasst, das dem Substrat Ausgangsgas und Reaktionsgas zuführt und verbleibendes Gas abführt und in dem Abscheidungsraum angeordnet ist; und
eine Substratträgereinheit (150), die unter der Gaszufuhreinheit angeordnet ist, auf der das Substrat angebracht ist und die in Bezug auf die Gaszufuhreinheit relativ bewegt wird,
wobei das Gaszufuhrmodul (200) ein Paar von Ausgangsgaszufuhrkanälen (210A und 210B), die dem Substrat Ausgangsgas zuführen, einen Reaktionsgaszufuhrkanal (220), der von dem Paar von Ausgangsgaszufuhrkanälen (210A und 210B) beabstandet ist und dem Substrat Reaktionsgas zuführt, und einen ersten Abführkanal (230), der zwischen dem Paar von Ausgangsgaszufuhrkanälen angeordnet ist und verbleibendes Gas abführt, umfasst, wobei das Gaszufuhrmodul (200) ferner ein Paar von ersten Spülgaszufuhrkanälen (250A und 250B) umfasst, die dem Substrat Spülgas zuführen und symmetrisch außerhalb des Paares von Ausgangsgaszufuhrkanälen angeordnet sind,
**dadurch gekennzeichnet, dass** ein Abführkanal, der verbleibendes Gas abführt, nicht zwischen dem Paar von Ausgangsgaszufuhrkanälen (210A und 210B) und dem Paar von ersten Spülgaszufuhrkanälen (250A und 250B), die jeweils nebeneinander liegen, angeordnet ist.

2. Dünnschichtabscheidungsvorrichtung nach Anspruch 1, wobei das Gaszufuhrmodul (200) ferner einen zweiten Abführkanal (232) umfasst, der zwischen dem Reaktionsgaszufuhrkanal (220) und einem aus dem Paar von ersten Spülgaszufuhrkanälen angeordnet ist.

3. Dünnschichtabscheidungsvorrichtung nach Anspruch 1, wobei das Gaszufuhrmodul (200) ferner einen zusätzlichen Abführkanal umfasst, der neben mindestens einer von beiden Rändern des Gaszufuhrmoduls angeordnet ist.

4. Dünnschichtabscheidungsvorrichtung nach Anspruch 3, wobei das Gaszufuhrmodul (200) ferner einen Spülgaszufuhrkanal umfasst, der außerhalb des zusätzlichen Abführkanals angeordnet ist.

5. Dünnschichtabscheidungsvorrichtung nach Anspruch 2, wobei das Paar von Ausgangsgaszufuhrkanälen (210A und 210B) und das Paar von ersten Spülgaszufuhrkanälen (250A und 250B) an einer Seite des Reaktionsgaszufuhrkanals (220) angeordnet sind und ein dritter Abführkanal (234) und ein zweiter Spülgaszufuhrkanal (252) ferner an der anderen Seite des Reaktionsgaszufuhrkanals angeordnet sind.

6. Dünnschichtabscheidungsvorrichtung nach Anspruch 5, wobei mindestens einer aus dem Paar von ersten Spülgaszufuhrkanälen (250A und 250B) und dem zweiten Spülgaszufuhrkanal (252) eine größere Breite aufweist als das Paar von Ausgangsgaszufuhrkanälen (210A und 210B) und der Reaktionsgaszufuhrkanal.

7. Dünnschichtabscheidungsvorrichtung nach Anspruch 5, wobei das Gaszufuhrmodul (200) ferner einen zusätzlichen Abführkanal umfasst, der neben mindestens einem von beiden Rändern des Gaszufuhrmoduls angeordnet ist.

8. Dünnschichtabscheidungsvorrichtung nach Anspruch 7, wobei das Gaszufuhrmodul (200) ferner einen dritten Spülgaszufuhrkanal umfasst, der zwischen dem Reaktionsgaszufuhrkanal und einem aus dem Paar von ersten Spülgaszufuhrkanälen angeordnet ist.

9. Dünnschichtabscheidungsvorrichtung nach Anspruch 8, wobei das Gaszufuhrmodul ferner einen vierten Abführkanal (254) umfasst, der zwischen dem Reaktionsgaszufuhrkanal und dem dritten Spülgaszufuhrkanal angeordnet ist.

10. Dünnschichtabscheidungsvorrichtung nach Anspruch 8, wobei mindestens einer aus dem Paar von ersten Spülgaszufuhrkanälen (250A und 250B), dem zweiten Spülgaszufuhrkanal (252) und dem dritten Spülgaszufuhrkanal (254) eine größere Breite aufweist als das Paar von Ausgangsgaszufuhrkanälen und der Reaktionsgaszufuhrkanal.

11. Dünnschichtabscheidungsvorrichtung nach Anspruch 5, wobei das Gaszufuhrmodul ferner ein Leitelement (610) umfasst, das an einem Ende von mindestens einem aus dem Paar von Ausgangsgaszufuhrkanälen (210A und 210B) angeordnet ist und eine Zufuhrrichtung des Ausgangsgases leitet.

12. Dünnschichtabscheidungsvorrichtung nach Anspruch 11, wobei das Leitelement (610) dazu ausgestaltet ist, von dem Paar von Ausgangsgaszufuhrkanälen (210A und 210B) zugeführtes Ausgangsgas so zu leiten, dass es zu dem ersten Abführkanal hin gerichtet wird.

## Revendications

1. Appareil de dépôt de film mince comprenant :
une chambre (100) fournissant un espace de dépôt (102) dans lequel un film mince est déposé sur un substrat (10) ;
une unité d'approvisionnement en gaz (2000) comprenant au moins un module d'approvisionnement en gaz (200) approvisionnant le substrat en gaz source et en gaz de réaction et évacuant le gaz restant, et disposée dans l'espace de dépôt ; et
une unité de support de substrat (150) qui est disposée sous l'unité d'approvisionnement en gaz, sur laquelle le substrat est monté, et qui est déplacée relativement à l'unité d'approvisionnement en gaz,
le module d'approvisionnement en gaz (200) comprenant une paire de canaux d'approvisionnement en gaz source (210A et 210B) approvisionnant le substrat en gaz source, un canal d'approvisionnement en gaz de réaction (220) à distance de la paire de canaux d'approvisionnement en gaz source (210A et 210B) et approvisionnant le substrat en gaz de réaction, et un premier canal d'évacuation (230) disposé entre la paire de canaux d'approvisionnement en gaz source et évacuant le gaz restant, le module d'approvisionnement en gaz (200) comprenant en outre une paire de premiers canaux d'approvisionnement en gaz de purge (250A et 250B) approvisionnant le substrat en gaz de purge et disposés symétriquement à l'extérieur de la paire de canaux d'approvisionnement en gaz source,
**caractérisé en ce qu'**aucun canal d'évacuation évacuant le gaz restant n'est disposé entre la paire de canaux d'approvisionnement en gaz source (210A et 210B) et la paire de premiers canaux d'approvisionnement en gaz de purge (250A et 250B), chacun étant adjacent l'un à l'autre.

2. Appareil de dépôt de film mince selon la revendication 1, le module d'approvisionnement en gaz (200) comprenant en outre un deuxième canal d'évacuation (232) disposé entre le canal d'approvisionnement en gaz de réaction (220) et un canal parmi la paire de premiers canaux d'approvisionnement en gaz de purge.

3. Appareil de dépôt de film mince selon la revendication 1, le module d'approvisionnement en gaz (200) comprenant en outre un canal d'évacuation supplémentaire disposé de façon adjacente à au moins l'un des deux bords du module d'approvisionnement en gaz.

4. Appareil de dépôt de film mince selon la revendication 3, le module d'approvisionnement en gaz (200) comprenant en outre un canal d'approvisionnement en gaz de purge disposé à l'extérieur du canal d'évacuation supplémentaire.

5. Appareil de dépôt de film mince selon la revendication 2, la paire de canaux d'approvisionnement en gaz source (210A et 210B) et la paire de premiers canaux d'approvisionnement en gaz de purge (250A et 250B) étant disposées sur un côté du canal d'approvisionnement en gaz de réaction (220), et un troisième canal d'évacuation (234) et un deuxième canal d'approvisionnement en gaz de purge (252) étant disposés en outre sur l'autre côté du canal d'approvisionnement en gaz de réaction.

6. Appareil de dépôt de film mince selon la revendication 5, au moins un canal parmi la paire de premiers canaux d'approvisionnement en gaz de purge (250A et 250B) et le deuxième canal d'approvisionnement en gaz de purge (252) ayant une largeur supérieure à celle de la paire de canaux d'approvisionnement en gaz source (210A et 210B) et du canal d'approvisionnement en gaz de réaction.

7. Appareil de dépôt de film mince selon la revendication 5, le module d'approvisionnement en gaz (200) comprenant en outre un canal d'évacuation supplémentaire disposé de façon adjacente à au moins l'un des deux bords du module d'approvisionnement en gaz.

8. Appareil de dépôt de film mince selon la revendication 7, le module d'approvisionnement en gaz (200) comprenant en outre un troisième canal d'approvisionnement en gaz de purge disposé entre le canal d'approvisionnement en gaz de réaction et un canal parmi la paire de premiers canaux d'approvisionnement en gaz de purge.

9. Appareil de dépôt de film mince selon la revendication 8, le module d'approvisionnement en gaz comprenant en outre un quatrième canal d'évacuation (254) disposé entre le canal d'approvisionnement en gaz de réaction et le troisième canal d'approvisionnement en gaz de purge.

10. Appareil de dépôt de film mince selon la revendication 8, au moins un canal parmi la paire de premiers canaux d'approvisionnement en gaz de purge (250A et 250B), le deuxième canal d'approvisionnement en gaz de purge (252) et le troisième canal d'approvisionnement en gaz de purge (254) ayant une largeur supérieure à celle de la paire de canaux d'approvisionnement en gaz source et du canal d'approvisionnement en gaz de réaction.

11. Appareil de dépôt de film mince selon la revendication 5, le module d'approvisionnement en gaz comprenant en outre un élément de guidage (610) disposé à une extrémité d'au moins un canal parmi la paire de canaux d'approvisionnement en gaz source (210A et 210B) et guidant une direction d'approvisionnement du gaz source.

12. Appareil de dépôt de film mince selon la revendication 11, l'élément de guidage (610) étant conçu pour guider le gaz source fourni par la paire de canaux d'approvisionnement en gaz source (210A et 210B), afin d'être dirigé vers le premier canal d'évacuation.
